# EUROPEAN PATENT SPECIFICATION

(11) **EP 2 124 518 B1**
(45) Date of publication and mention of the grant of the patent: **20.03.2013**
(21) Application number: 09006732.3
(22) Date of filing: 19.05.2009
(51) Int. Cl.: H05K 7/20, H02B 1/56, F24F 5/00

(54) **Cabinet temperature control system**
Schranktemperatursteuersystem
Système de contrôle de température d'une armoire

(30) Priority: 23.05.2008 CN 200810067337; 10.04.2009 WO PCT/CN2009/071225
(43) Date of publication of application: 25.11.2009
(73) Proprietor: Huawei Technologies Co., Ltd., Longgang District, Shenzhen Guangdong 518129 (CN)
(72) Inventor: Wu, Weixing, Shenzhen Guangdong Province 518129 (CN); Hong, Yuping, Shenzhen Guangdong Province 518129 (CN); Zhai, Liqian, Shenzhen Guangdong Province 518129 (CN); Kong, Xiaoming, Shenzhen Guangdong Province 518129 (CN)
(74) Representative: Pfenning, Meinig & Partner GbR

(56) References cited:
- EP-A- 0 848 469
- WO-A-2009/006908
- US-A- 4 674 561
- US-A- 5 216 577

## Description

### FIELD OF THE INVENTION

The invention relates to a temperature control system, in particular, to a cabinet, and a cabinet temperature control system.

### BACKGROUND OF THE INVENTION

With the development of earthly industry, the consumption of various resources is getting more and more considerable and the environment is getting more and more deteriorative, some apparent phenomena of which include the greenhouse effect and acid rain, etc. It has become our common concern how to protect our earth and how to take advantage of limited resources to promote further industrial development.

Electronic equipment has a stricter requirement for the operation environment temperature thereof. Generally, electronic equipment may emit heat during operating, and the emitted heat may gather in the surrounding environment of the equipment, thereby causing the operation environment temperature of the electronic equipment to be risen. When the operation environment temperature rises up to a certain extent, the electronic equipment would not work normally. Therefore, a refrigerating air conditioner or other cooling apparatus are often provided for the electronic equipment. Similarly, if the environmental temperature is too low, the operation of the electronic equipment would be affected. Therefore, the electronic equipment located at a low temperature region may need to be heated.

Nowadays, a natural cooling solution for an outdoor cabinet is widely applied to medium and low power outdoor equipment. In order to enhance the cooling ability of outdoor cabinet and to improve the power consumption level of outdoor equipment, in addition to the installation of a heat insulation layer or the addition of a sun shielding cover at the top of existing outdoor equipment, a wrinkled-wall structure of the outdoor cabinet is adopted to effectively increase the heat dissipating area, which is a usually-taken measure to enhance the natural heat exchanging ability. Air heated by power consuming equipment circulates inside the cabinet and exchanges heat with the outside environment via the walls of cabinet to maintain the normal operation of equipment arranged inside the cabinet.

Presently, electronic equipment is designed with more and more powerful functions as well as higher and higher integration. How to improve the cooling ability of electronic equipment under the premise of being environmentally friendly and energy-saving becomes a problem that needs to be solved urgently.

Related prior art are cited here as follows:

CN 28362819 discloses an underground airlight transformer room with thermo-tube radiation, comprising a set of thermotubes penetrating the wall part of the room with heat absorption sections arranged in the room and radiating sections arranged outside the room, both sections provided with radiating fins, so that heat absorbed from room air, transformer oil and heat collecting tank liquid is conveyed into outdoor out or surrounding soil.

US-A-5 216 577 discloses an enclosure for outdoor electronics having an underground ground sleeve for providing a heat exchanger between the surrounding ground and a first fluid circuit.

US-A-4 674 561 discloses an air temperature control system which is highly energy efficient and virtually maintenance free. The system includes an intake conduit for receiving air at a non-selected temperature, an exit conduit for delivering the air at a controlled temperature to a preselected location, a heat exchanger located below the surface of the ground, and a heat sink preferably of limestone which surrounds the heat exchanger and which adjusts the temperature of the air flowing through the heat exchanger to a controlled temperature. A fan effects the flow of air through the system.

EP-A-0848 469 is also cited here for showing some related prior art.

### SUMMARY OF THE INVENTION

An embodiment of the invention provides a cabinet temperature control system which takes the advantage of a ground source heat pump system and makes full use of the cold and heat storage effect of shallow soil to improve the cooling efficiency and reliability.

The cabinet temperature control system of claim 1 includes a cabinet and an underground temperature control unit, in which
the cabinet includes an air discharging chamber and an air introducing chamber and the air discharging chamber and the air introducing chamber of the cabinet are in communication with each other inside the cabinet;
the underground temperature control unit includes an air discharging chamber and an air introducing chamber and the air discharging chamber and the air introducing chamber of the underground temperature control unit are in communication with each other inside the underground temperature control unit;
the air discharging chamber of the cabinet and the air introducing chamber of the underground temperature control unit are in communication with each other, and the air discharging chamber of the underground temperature control unit and the air introducing chamber of the cabinet are in communication with each other, so that the cabinet and the underground temperature control unit form an air circulating circuit; and
the underground temperature control unit further includes a radiator arranged in the air circulating circuit; and
the underground temperature control unit (20) further includes an underground base (21) having a radiator (203), and wherein one end of the radiator (203) is positioned inside the underground base (21) while the other end penetrates the underground base (21) and extends into the soil or underground water around the underground base (21); wherein both the inside portion and the extending portion of the radiator (203) are provided with a radiating fin (204).

Meanwhile, an embodiment of the invention also provides an underground temperature control apparatus, the interior of the underground temperature control apparatus includes an air discharging chamber and an air introducing chamber, and the air discharging chamber and the air introducing chamber of the underground temperature control apparatus are in communication with each other inside the apparatus; the air discharging chamber and the air introducing chamber of the underground temperature control apparatus are in communication with an air introducing chamber and an air discharging chamber of an external equipment, respectively, so that an air circulating circuit is formed between the underground temperature control apparatus and the external device; and
the underground temperature control unit further includes a radiator arranged in the air circulating circuit.

Further, a cabinet is provided. The cabinet includes an air discharging chamber and an air introducing chamber and the air discharging chamber and the air introducing chamber of the cabinet are in communication with each other inside the cabinet; and
the air discharging chamber and the air introducing chamber of the cabinet are in communication with an air introducing chamber and an air discharging chamber of an underground cooling apparatus respectively, so that an air circulating circuit is formed between the cabinet and the underground cooling apparatus.

The cabinet temperature control system according to the embodiments of the invention includes a cabinet and an underground temperature control unit, each of the cabinet and the underground temperature is provided with an air discharging chamber and an air introducing chamber, these air discharging chambers and air introducing chambers are in communication with each other to form an air circulating circuit. The air circulates in the air circulating circuit by the action of an air transferring device, so that, in combination with a temperature adjusting function of the underground temperature control unit, air inside the cabinet can reach an appropriate temperature. The system makes sufficient use of the cold and heat storage effect of shallow soil to improve the cooling efficiency and reliability and is environmentally friendly as well as energy-saving.

### BRIEF DESCRIPTION OF THE DRAWINGS

Figure 1 is a structural schematic diagram showing a temperature control system for a cabinet according to an embodiment of the present invention;

Figure 2 is a structural schematic diagram showing a radiator of the system shown in Figure 1 with a heat radiating fin at one end thereof;

Figure 3 is a structural schematic top view showing the arrangement of heat pipes in the system shown in Figure 1; and

Figure 4 shows a structural schematic diagram of a cabinet temperature control system according to another embodiment of the present invention.

### DETAILED DESCRIPTION

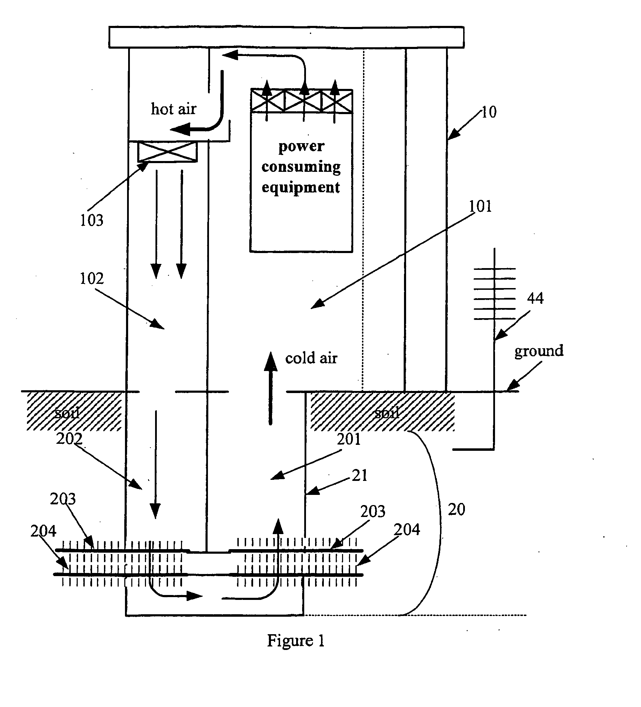

As shown in Figure 1, a cabinet temperature control system according to an embodiment of the invention includes a cabinet 10 arranged over the ground and an underground temperature control unit 20 arranged under the ground.

An air introducing chamber 101 and an air discharging chamber 102 are formed inside the cabinet 10, and the air introducing chamber 101 and the air discharging chamber 102 are in communication with each other at the interior top end of the cabinet 10, with the air discharging chamber 102 being the outlet of the heat air channel in the cabinet 10.

An air discharging chamber 201 and an air introducing chamber 202 are also formed inside the underground temperature control unit 20, and the air discharging chamber 201 and the air introducing chamber 202 are in communication with each other at the interior bottom end of the underground temperature control unit 20.

The air discharging chamber 102 inside the cabinet 10 is in communication with the air introducing chamber 202 inside the underground temperature control unit 20, and the air discharging chamber 201 inside the underground temperature control unit 20 is in communication with the air introducing chamber 101 inside the cabinet 10, thereby forming an air circulating circuit.

An air transferring device 103 is installed in the air circulating circuit. In this embodiment, the air transferring device 103 is a fan. Air inside the closed system flow within the air circulating circuit by the action of the air transferring device 103, so that, in combination with a temperature adjusting function of the underground temperature control unit 20, air inside the cabinet 10 can reach an appropriate temperature.

The underground temperature control unit 20 includes an underground base 21 having a radiator 203 therein. The radiator 203 may be positioned in each of the air introducing chamber 202 and the air discharging chamber 201. Alternatively, only one radiator 203 may be installed in one of the air introducing chamber 202 and the air discharging chamber 201. One end of the radiator 203 is positioned inside the underground base 21, while the other end penetrates the underground base 21 and extends into the soil or underground water around the underground base 21.

The radiator 203 exhibits a good heat exchanging effect since one end of the radiator 203 is inside the underground base 21 while the other end is in contact with the soil or underground water. Ori one hand, the high temperature of air inside the underground base 21 can be transferred into the earth so as to lower the temperature of the cabinet 10; on the other hand, the high temperature inside the earth can be transferred to the air inside the underground base 21 so as to rise the temperature of the cabinet 10.

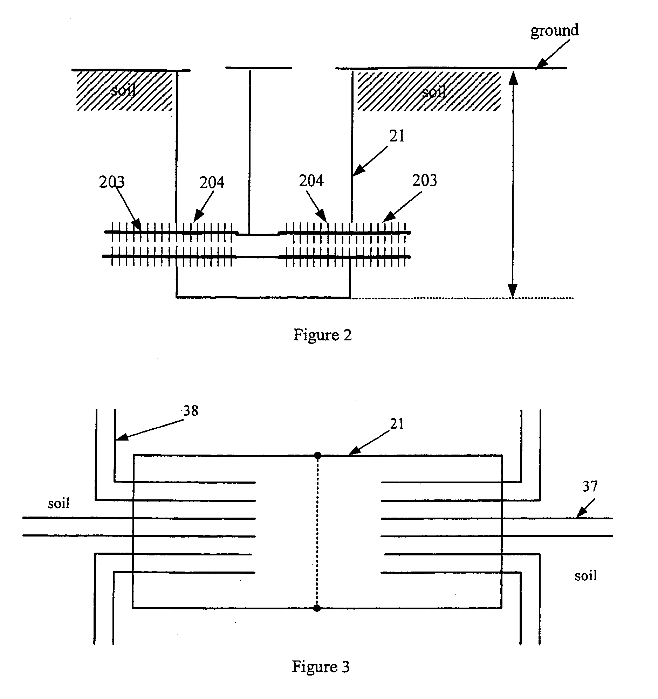

In order to improve the heat exchange efficiency, a portion of the radiator 203 which is located inside the underground base 21 is provided with a radiating fin 204. The structure of the underground base 21 having such a radiating fin is shown in Figure 2. A portion of the radiator 203 which extends into the soil or underground water around the underground base 21 is also provided with a radiating fin 204. The radiating fin 204 can increase the contact area of the radiator 203 with the soil or underground water, resulting in a faster heat exchange.

In order to prevent the radiator 203 from being eroded, the portion of the radiator 203 which extends into the soil or underground water around the underground base 21 is made of ceramics, or made of stainless steel or shaped material coated with plastic on the outer surface, in order that the radiator 203 can be better protected from being eroded or rusted.

Meanwhile, in order to protect the equipment and increase the efficiency of temperature control, a seal connection is provided between the radiator 203 and the underground base 21. As one selectable solution, the radiator 203 is connected with the underground base 21 via a flange plate, i.e., a dual-face flange plate is provided at the middle portion of the radiator 203 and is embed into the underground 21 with a sealing rubber ring being combined to ensure the hermeticity. As another selectable solution, the radiator 203 is connected with the underground base 21 by welding together to ensure the hermeticity.

In this embodiment, the radiator 203 serves to perform the heat exchange and is preferably a heat pipe radiator. If one single heat pipe is provided, the connection with the underground base 21 via the flange plate is preferred. If a plurality of heat pipes is provided, it is preferred that the plurality of heat pipes be made into an entirety and welded to the underground base 21 so as to ensure the hermeticity. As the heat pipe radiator, a linear heat pipe or L-shaped heat pipe may be used to avoid heat concentration on one location and enhance heat exchange ability.

Figure 3 is a schematic top view showing the structure of the underground base 21 when the combination of the linear heat pipe 37 and the L-shaped heat pipe 38 are used to the heat pipe radiator 203.

Since soil in different regions has different heat transfer coefficients and the heat transfer coefficient of soil is low, in order to avoid accumulating heat in the soil and facilitate to emit heat from the soil timely when heat is transferred into the soil, a prior unidirectional heat transferring technology by means of a hot bar can be adopted. As shown in Figure 1, a hot bar 44 is arranged in the peripheral region around the underground temperature control unit 20 so that one end of the hot bar 44 projects above the ground (on which end a radiating fin can be provided). When the soil temperature is higher than the air temperature, the hot bar 44 operates, thereby transferring heat from the soil to the atmosphere. With the ease of installation during construction and heat exchange efficiency of the earth taken into consideration, the distance from the bottom of the underground base 21 to the ground can be more than 1.5 m and less than 3 m.

In practice, the cabinet 10 may be placed on a high platform, the air discharging chamber 102 inside the cabinet 10 and the air introducing chamber 202 inside the underground temperature control unit 20 are in communication with each other via an air conducting pipe, and the air introducing chamber 101 inside the cabinet 10 and the air discharging chamber 201 inside the underground temperature control unit 20 are in communication with each other via an air conducting pipe. The air discharging chamber 201 and the air introducing 202 inside the underground temperature control unit 20 may also be in communication with each other via an air conducting pipe at the interior bottom end of the underground temperature control unit 20.

Furthermore, the air transferring device 103 serves to cause air flow between the cabinet 10 and the underground temperature control unit 20. The air transferring device 103 can be a fan or a pump or other devices and is preferably installed near the position where the air discharging chamber 102 and air introducing chamber 101 inside the cabinet 10 are in communication with each other to ensure well fluidity of the air.

When the embodiments of the invention are implemented, the cabinet is generally a cabinet provided with electronic equipment therein. Since hot air flows upwardly, the electronic equipment can be provided in the air introducing chamber 101 of the cabinet for ease of cooling the electronic equipment.

In actual application, air inside the cabinet 10 on the ground is transferred to the underground temperature control unit 20. The underground temperature control unit 20 makes the air exchange heat with the underground soil or underground water. Specifically, the air exchanges heat with the underground soil or underground water via the radiator 203 provided on the underground temperature control unit 20. The heat-exchanged air is fed back to the cabinet 10.

. The cabinet temperature control method of the embodiments of the invention causes air to circulate in the cabinet and the underground temperature control unit. The underground temperature control unit causes air to exchange heat with the underground soil or underground water so that the air inside the cabinet reaches an appropriate temperature. The system makes sufficient use of the cold and heat storage effect of shallow soil to improve the cooling efficiency and reliability and is environmentally friendly as well as energy-saving.

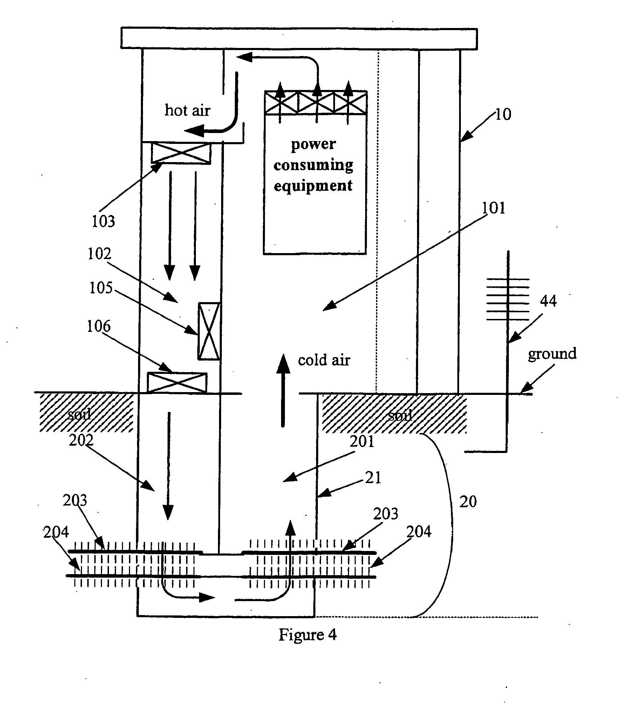

To improve the flexibility of the cooling system, a system fan is additionally provided in the channel of the air discharging chamber 102 of the cabinet. Figure 4 shows a schematic view of another embodiment of the invention. The difference from the above embodiment is the addition of the system fan, which includes a ground source system fan 106 for transferring hot air into the underground temperature control unit 20 and an internal circulating fan 105 for providing hot air circulating inside the cabinet. A control module (not shown) can be additionally provided to control turn-on/turn-off as well as rotational speed of the fans. The ground source system fan 106 is positioned between the air discharging chamber 102 of the cabinet 10 and the air introducing chamber 202 of the underground temperature control unit 20, and forces air into the underground temperature control unit 20 from the cabinet 10 when operating. The internal circulating fan 105 is positioned between the air discharging chamber 102 and the air introducing chamber 101 of the cabinet 10, and forces air into the air introducing chamber of the cabinet from the air discharging chamber of the cabinet 10 when operating, thereby causing the air to circulate between the hot air channel and the interior of the cabinet.

The operation of the system and cabinet according to the embodiments of the invention will be described in combination with the control strategy of the control module for the system. Ta is defined as an environmental air temperature, T0 is defined as a reference temperature which is used as a main criterion for determining whether or not to employ ground source cooling solution, Te is a temperature allowable for the equipment, and Tmax is the maximum temperature allowable for the equipment. If Ta>T0, the outdoor cabinet employs the ground source cooling solution, and, at this time, the system fan 106 starts up and runs at a full speed while the internal circulating fan 105 stops. During the operation of the equipment, the control module makes a comparison analysis between the acquired value of Te and Tmax. If Te<Tmax, the fan is controlled with respect to the rotational speed according to a build-in rotational speed adjusting strategy. If Te>Tmax, power consumption of the equipment exceeds the cooling capacity of the cooling system and the fan runs at full speed. If Ta<T0 and Te<Tmax, in the outdoor cabinet, the natural cooling solution using cabinet walls is employed, and, at this time, the internal circulating fan 105 starts up and runs at the full speed while the system fan 106 stops. During the operation of the equipment, the control module makes a comparison analysis between the acquired value of Te and Tmax. If Te>Tmax, the ground source cooling solution is initiated, and, at this time, the ground source system fan 106 starts up while the internal circulating fan 105 stops; and if Te<Tmax, the rotational speed is adjusted according to the build-in rotational speed adjusting strategy.

The addition of system fan in the above embodiment increases the flexibility on the cabinet cooling solution, and it is easy to restore the soil temperature due to the use of internal circulating fan.

Described above are only particular embodiments of the invention and scope of protection of the invention is not limited thereto. People skilled in the art can, within the technical scope disclosed in the invention, easily conceive modifications and replacements that should fall within the scope of protection of the invention. Therefore, the scope of protection of the invention should be defined by the scope of protection claimed in the claims.

## Claims

1. A cabinet temperature control system comprising a cabinet (10) and an underground temperature control unit (20), wherein:
the cabinet (10) comprises an air discharging chamber (102) and an air introducing chamber (101), and the air discharging chamber (102) and the air introducing chamber (101) of the cabinet (10) are in communication with each other inside the cabinet (10);
the underground temperature control unit (20) comprises an air discharging chamber (201) and an air introducing chamber (202), and the air discharging chamber (201) and the air introducing chamber (202) of the underground temperature control unit (20) are in communication with each other inside the underground temperature control unit (20);
the air discharging chamber (102) of the cabinet (10) and the air introducing chamber (202) of the underground temperature control unit (20) are in communication with each other, and the air discharging chamber (201) of the underground temperature control unit (20) and the air introducing chamber (101) of the cabinet (10) are in communication with each other, so that an air circulating circuit is formed in the cabinet (10) and the underground temperature control unit (20); and
the underground temperature control unit (20) further comprises an underground base (21) having a radiator (203), and wherein one end of the radiator (203) is positioned inside the underground base (21) while the other end penetrates the underground base (21) and extends into the soil or underground water around the underground base (21); wherein both the inside portion and the extending portion of the radiator (203) are provided with a radiating fin (204); the radiator arranged in the air circulating circuit.

2. The cabinet temperature control system according to claim 1, wherein the system further comprises an air transferring device (103) arranged in the air circulating circuit, air inside the system flow within the air circulating circuit by the action of the air transferring device (103).

3. The cabinet temperature control system according to claim 1, wherein the cabinet (10) further comprises a ground source system fan (106), an internal circulating fan (105) and a control module;
the ground source system fan (106) is positioned between the air discharging chamber (102) of the cabinet (10) and the air introducing chamber (202) of the underground temperature control unit (20), and transfers air into the underground temperature control unit (20) from the cabinet (10) when the ground source system fan (106) operates;
the internal circulating fan (105) is positioned between the air discharging chamber (102) and the air introducing chamber (101) of the cabinet (10), and introduces air into the air introducing chamber (101) of the cabinet (10) from the air discharging chamber (102) of the cabinet (10) when the internal circulating fan (105) operates; and
the control module is adapted to control turn-on/turn-off of the ground source system fan (106) and the internal circulating fan (105).

4. The cabinet temperature control system according to claim 3, wherein the portion of the radiator (203) which extends into the soil or underground water around the underground base (21) is made of ceramics, or made of stainless steel or shaped material coated with plastic on the outer surface.

5. The cabinet temperature control system according to claim 1, wherein a seal connection is provided between the radiator (203) and the underground base (21).

6. The cabinet temperature control system according to claim 5, wherein the seal connection is carried out in such a manner that that the radiator (203) is connected with the underground base (21) via a flange plate, or the radiator (203) is connected with the underground base (21) by welding together to ensure the hermeticity.

7. The cabinet temperature control system according to claim 1, wherein the radiator (203) comprises a linear heat pipe (37) or an L-shape heat pipe (38).

## Patentansprüche

1. Schranktemperatur-Steuersystem, das einen Schrank (10) und eine Untergrund-Temperatursteuereinheit (20) umfasst, wobei:
der Schrank (10) eine Luftablasskammer (102) und eine Lufteinleitkammer (101) umfasst, wobei die Luftablasskammer (102) und die Lufteinleitkammer (101) des Schranks (10) innerhalb des Schranks (10) miteinander in Verbindung stehen;
die Untergrund-Temperatursteuereinheit (20) eine Luftablasskammer (201) und eine Lufteinleitkammer (202) umfasst, wobei die Luftablasskammer (201) und die Lufteinleitkammer (202) der Untergrund-Temperatursteuereinheit (20) innerhalb der Untergrund-Temperatursteuereinheit (20) miteinander in Verbindung stehen;
die Luftablasskammer (102) des Schranks (10) und die Lufteinleitkammer (202) der Untergrund-Temperatursteuereinheit (20) miteinander in Verbindung stehen und die Luftablasskammer (201) der Untergrund-Temperatursteuereinheit (20) und die Lufteinleitkammer (101) des Schranks (10) miteinander in Verbindung stehen, so dass in dem Schrank (10) und der Untergrund-Temperatursteuereinheit (20) ein Luftzirkulationskreislauf gebildet ist; und
die Untergrund-Temperatursteuereinheit (20) ferner eine Untergrundbasis (21) umfasst, die einen Radiator (203) besitzt, und wobei ein Ende des Radiators (203) innerhalb der Untergrundbasis (21) positioniert ist, während das andere Ende die Untergrundbasis (21) durchdringt und sich in das Erdreich oder das unterirdische Wasser um die Untergrundbasis (21) erstreckt; wobei sowohl der innere Abschnitt als auch der sich erstreckende Abschnitt des Radiators (203) mit einer Kühlrippe (204) versehen sind; wobei der Radiator innerhalb des Luftzirkulationskreislaufs angeordnet ist.

2. Schranktemperatur-Steuersystem nach Anspruch 1, wobei das System ferner eine Luftübertragungsvorrichtung (103) umfasst, die in dem Luftzirkulationskreislauf angeordnet ist, wobei die Luft innerhalb des Systems durch die Wirkung der Luftübertragungsvorrichtung (103) innerhalb des Luftzirkulationskreislaufs strömt.

3. Schranktemperatur-Steuersystem nach Anspruch 1, wobei der Schrank (10) ferner einen Boden-Quellsystem-Ventilator (106), einen internen Zirkulationsventilator (105) und ein Steuermodul umfasst;
wobei der Boden-Quellsystem-Ventilator (106) zwischen der Luftablasskammer (102) des Schranks (10) und der Lufteinleitkammer (202) der Untergrund-Temperatursteuereinheit (20) positioniert ist und Luft aus dem Schrank (10) in die Untergrund-Temperatursteuereinheit (20) überträgt, wenn der Boden-Quellsystem-Ventilator (106) arbeitet;
der interne Zirkulationsventilator (105) zwischen der Luftablasskammer (102) und der Lufteinleitkammer (101) des Schranks (10) positioniert ist und Luft aus der Luftablasskammer (102) des Schranks (10) in die Lufteinleitkammer (101) des Schranks (10) einleitet, wenn der interne Zirkulationsventilator (105) arbeitet; und das Steuermodul dafür ausgelegt ist, das Einschalten/Ausschalten des Boden-Quellsystem-Ventilators (106) und des internen Zirkulationsventilators (105) zu steuern.

4. Schranktemperatur-Steuersystem nach Anspruch 3, wobei der Anteil des Radiators (203), der sich in das Erdreich oder das unterirdische Wasser um die Untergrundbasis (21) erstreckt, aus Keramik besteht oder aus Edelstahl oder einem geformten Material, der bzw. das auf der Außenseite mit Kunststoff beschichtet ist, besteht.

5. Schranktemperatur-Steuersystem nach Anspruch 1, wobei eine Dichtungsverbindung zwischen dem Radiator (203) und der Untergrundbasis (21) vorgesehen ist.

6. Schranktemperatur-Steuersystem nach Anspruch 5, wobei die Dichtungsverbindung auf eine derartige Art ausgeführt ist, dass der Radiator (203) über eine Flanschplatte mit der Untergrundbasis (21) verbunden ist oder der Radiator (203) durch Zusammenschweißen mit der Untergrundbasis (21) verbunden ist, um die hermetische Dichtheit sicherzustellen.

7. Schranktemperatur-Steuersystem nach Anspruch 1, wobei der Radiator (203) ein geradliniges Wärmerohr (37) oder ein L-förmiges Wärmerohr (38) umfasst.

## Revendications

1. Système de contrôle de température d'une armoire comprenant une armoire (10) et une unité de contrôle de température souterraine (20), dans lequel :
l'armoire (10) comprend une chambre de décharge d'air (102) et une chambre d'introduction d'air (101), et la chambre de décharge d'air (102) et la chambre d'introduction d'air (101) de l'armoire (10) sont en communication l'une avec l'autre à l'intérieur de l'armoire (10) ;
l'unité de contrôle de température souterraine (20) comprend une chambre de décharge d'air (201) et une chambre d'introduction d'air (202), et la chambre de décharge d'air (201) et la chambre d'introduction d'air (202) de l'unité de contrôle de température souterraine (20) sont en communication l'une avec l'autre à l'intérieur de l'unité de contrôle de température souterraine (20) ;
la chambre de décharge d'air (102) de l'armoire (10) et la chambre d'introduction d'air (202) de l'unité de contrôle de température souterraine (20) sont en communication l'une avec l'autre et la chambre de décharge d'air (201) de l'unité de contrôle de température souterraine (20) et la chambre d'introduction d'air (101) de l'armoire (10) sont en communication l'une avec l'autre, de telle sorte qu'un circuit de circulation d'air soit formé dans l'armoire (10) et dans l'unité de contrôle de température souterraine (20) ; et
l'unité de contrôle de température souterraine (20) comprend en outre une base souterraine (21) ayant un radiateur (203), et dans lequel une extrémité du radiateur (203) est positionnée à l'intérieur de la base souterraine (21) tandis que l'autre extrémité pénètre à travers la base souterraine (21) et s'étend jusque dans le sol ou
l'eau souterraine autour de la base souterraine (21) ; dans lequel la portion intérieure et la portion étendue du radiateur (203) sont chacune pourvues d'une ailette irradiante (204) ; le radiateur étant agencé dans le circuit de circulation d'air.

2. Système de contrôle de température d'une armoire selon la revendication 1, dans lequel le système comprend en outre un dispositif de transfert d'air (103) agencé dans le circuit de circulation d'air, et l'air à l'intérieur du système s'écoule à l'intérieur du circuit de circulation d'air sous l'effet du dispositif de transfert d'air (103).

3. Système de contrôle de température d'une armoire selon la revendication 1, dans lequel l'armoire (10) comprend en outre un ventilateur de système de source géothermique (106), un ventilateur de circulation interne (105) et un module de commande ;
le ventilateur de système de source géothermique (106) est positionné entre la chambre de décharge d'air (102) de l'armoire (10) et la chambre d'introduction d'air (202) de l'unité de contrôle de température souterraine (20), et transfère de l'air dans l'unité de contrôle de température souterraine (20) depuis l'armoire (10) lorsque le ventilateur de système de source géothermique (106) fonctionne ;
le ventilateur de circulation interne (105) est positionné entre la chambre de décharge d'air (102) et la chambre d'introduction d'air (101) de l'armoire (10) et introduit de l'air dans la chambre d'introduction d'air (101) de l'armoire (10) depuis la chambre de décharge d'air (102) de l'armoire (10) lorsque le ventilateur de circulation interne (105) fonctionne ; et
le module de commande est prévu pour commander la mise en marche / l'arrêt du ventilateur de système de source géothermique (106) et du ventilateur de circulation interne (105).

4. Système de contrôle de température d'une armoire selon la revendication 3, dans lequel la portion du radiateur (203) qui s'étend dans le sol ou l'eau souterraine autour de la base souterraine (21) est fabriquée en céramique, ou en acier inoxydable ou en matériau façonné revêtu de plastique sur la surface externe.

5. Système de contrôle de température d'une armoire selon la revendication 1, dans lequel une connexion scellée est prévue entre le radiateur (203) et la base souterraine (21).

6. Système de contrôle de température d'une armoire selon la revendication 5, dans lequel la connexion scellée est réalisée de telle sorte que le radiateur (203) soit connecté à la base souterraine (21) par le biais d'une plaque à bride, ou le radiateur (203) est connecté à la base souterraine (21) par soudage mutuel pour assurer l'étanchéité.

7. Système de contrôle de température d'une armoire selon la revendication 1, dans lequel le radiateur (203) comprend un conduit de chaleur linéaire (27) ou un conduit de chaleur en forme de L (3 8).
